# EUROPÄISCHE PATENTSCHRIFT

(11) **EP 1 435 505 B1**
(45) Veröffentlichungstag und Bekanntmachung des Hinweises auf die Patenterteilung: **27.01.2010**
(21) Anmeldenummer: 03025125.0
(22) Anmeldetag: 03.11.2003
(51) Int. Cl.: F28D 15/02, F28D 15/04

(54) **Wärmesenke in Form einer Heat-Pipe sowie Verfahren zum Herstellen einer solchen Wärmesenke**
Watersink as heat pipe and method of fabricating such a watersink
Caloducte et méthode de fabrication

(30) Priorität: 30.12.2002 DE 10261402
(43) Veröffentlichungstag der Anmeldung: 07.07.2004
(73) Patentinhaber: Electrovac AG, 3400 Klosterneuburg (AT)
(72) Erfinder: Dr.-Ing. Jürgen Schulz-Harder, 91207 Lauf (DE)
(74) Vertreter: Graf, Helmut

(56) Entgegenhaltungen:
- US-A1- 2002 092 166
- US-B1- 6 227 287
- US-B1- 6 302 192
- US-B1- 6 437 437

## Beschreibung

Die Erfindung bezieht sich auf eine Wärmesenke in Form einer Heat-Pipe gemäß Oberbegriff Patentanspruch 1 sowie auf ein Verfahren gemäß Oberbegriff Patentanspruch 14.

Eine als flache, plattenförmige Heat-Pipe ausgebildete Wärmesenke ist bekannt (US 3,680,189). Die bekannte Wärmesenke besteht im wesentlichen aus einem quader- oder plattenförmigen Hohlkörper, dessen Innenraum von zwei, die Oberseite bzw. Unterseite bildenden Wänden sowie von einer Umfangswand begrenzt ist. An den Innenflächen der die Oberseite und Unterseite bildenden Wandabschnitte ist jeweils eine eine kapillare oder poröse Struktur bildende Lage oder Schicht vorgesehen. Durch mehrere im Innenraum des Hohlkörpers angeordnete und räumlich gegeneinander versetzte Pfosten sind diese Lagen an ihren zugehörigen Wänden gehalten. Der Innenraum des Hohlkörpers dient zur Aufnahme eines leicht verdampfbare Wärme transportierenden Mediums. Dieses wird zum Kühlen beispielsweise eines elektrischen, Verlustwärme erzeugenden und an der Heat-Pipe vorgesehenen Bauelementes an einem Verdampfungsbereich, d. h. dort wo sich das Bauelement befindet, verdampft und an einem von diesem Verdampfungsbereich räumlich entfernten Kondensationsbereich, d. h. dort wo die Wärme abgeführt wird, kondensiert und kann dann in den kapillaren Strukturen zurück an den Verdampfungsbereich fließen.

Bekannt ist weiterhin das sogenannte DCB-Verfahren (Direct-Gopper-Bond-Technology). Mit diesem z. B. in der US-PS 37 44 120 oder in der DE-PS 23 19 854 beschriebenen Verfahren ist es möglich, Metalle, beispielsweise Kupfer miteinander oder aber Metalle mit Keramik flächig zu verbinden, wobei die Metalle an ihren Oberflächen eine Schicht oder einen Überzug (Aufschmelzschichl) aus einer chemischen Verbindung aus dem Metall und einem reaktiven Gas, bevorzugt Sauerstoff aufweisen. Diese Aufschmelzschicht bildet ein Eutektikum mit einer Schmelztemperatur unterhalb der Schmelztemperatur des Metalles (z. B. Kupfer), so daß nach dem Aneinanderfügen der zu verbindenden Materialien diese durch Erhitzen miteinander verbunden werden können, und zwar durch Aufschmelzen der Aufschmelzschicht. Die Prozesstemperatur liegt bei diesem DCB-Prozess zwischen etwa 1025 und 1083° C.

Aus der Druckschrift US 6 302 192 B1 ist eine Heat-Pipe bekannt, die aus einer Kontaktplatte mit umlaufendem Rahmen und einer Abdeckplatte mit einer Vielzahl von Senken besteht. Im Inneren der Heat-Pipe sind eine Vielzahl von Kammern ausgebildet, die teilweise umfangsseitig eine kapillare Struktur aus gesintertem Metall aufweisen. Als gesintertes Material wird hierbei Kupferpulver oder Silberpulver vorgeschlagen.

Druckschrift US 6 227 287 B1 offenbart eine Kühlvorrichtung zur Kühlung eines Wärme abgebenden Elements, beispielsweise einem Mikroprozessor, wobei die Kühlvorrichtung zumindest einen Innenraum aufweist, dessen dem Wärme erzeugenden Bauelement zugewandte Innenseite eine Schicht aus porösem metallischem gesinterten Material aufweist.

Aus der Druckschrift US 6 437 437 B1 ist eine Halbleiterbaugruppe mit integrierter Hitzeverteilung bekannt. Hierbei wird ein im Inneren der Halbleiterbaugruppe angeordneter Halbleiterchip von einem Material mit kapillarer Struktur oberseitig bedeckt oder glockenartig umgriffen. Als Material für diese kapillare Schicht schlägt die Druckschrift Aluminium-Siliziumkarbid vor.

Aufgabe der Erfindung ist es, eine Heat-Pipe aufzuzeigen, die sich durch einen verbesserten Wirkungsgrad auszeichnet. Zur Lösung dieser Aufgabe ist eine Wärmesenke bzw. Heat-Pipe entsprechend dem Patentanspruch 1 ausgebildet. Ein Verfahren zur Herstellung der Wärmesenke ist entsprechend dem Patentanspruch 14 ausgebildet. Eine Besonderheit der Erfindung besteht darin, daß zwischen den beiden, den Innenraum begrenzenden, einander gegenüberliegenden ersten Wandabschnitten oder Wandungen des die Heat-Pipe bildenden Hohlkörpers räumlich voneinander getrennt mehrere Pfosten vorgesehen sind, die ummittelbar mit diesen Wandungen verbunden sind und ebenso wie diese Wandabschnitte aus einem Material mit hoher Wärmeleitfähigkeit, beispielsweise aus Metall, z. B. Kupfer bestehen.

Entsprechend weiterer Ausgestaltungen der Erfindung ist der wenigstens eine kapillare oder poröse Bereich (Flüssigkeitsraum) von einer Vielzahl von Partikeln gebildet, die durch Bonden und/oder Sintern miteinander verbunden sind und/oder eine lose Schüttung bilden, und zwar derart, daß sich zwischen den Partikeln hindurch kapillare Strömungswege ergeben. Die Partikel sind dabei bevorzugt solche aus Keramik, beispielsweise aus einer Alumininumoxid-Keramik, die dann durch Anwendung der DCB-Bond-Technik zu der kapillaren Struktur miteinander, aber auch mit angrenzenden Flächen des Heatpipe-Körpers verbunden sind.

Eine weitere mögliche Ausführungsform der Erfindung ist dadurch gekennzeichnet, daß die kapillare bzw. poröse Struktur aus Partikeln besteht, die durch Bonden oder Sintern derart miteinander und/oder mit einer benachbarten Fläche verbunden sind, daß sich zwischen den Partikeln kapillare Strömungswege ergeben.

Eine weitere mögliche Ausführungsform der Erfindung ist gekennzeichnet durch mehrere durch den Innenraum hindurchreichende und sich zwischen zwei einander gegenüber liegenden, den Innenraum begrenzenden Wandungen oder Wandabschnitten erstreckende und räumlich voneinander getrennte Pfosten, wobei die Pfosten sowie die einander gegenüberliegenden Wandabschnitte jeweils aus einem Material hoher Wärmeleitfähigkeit, beispielsweise aus Metall, z.B. aus Kupfer bestehen, und wobei jeder Pfosten beidendig unmittelbar mit einem der einander gegenüberliegenden Wandabschnitte verbunden ist.

Eine weitere mögliche Ausführungsform der Erfindung ist dadurch gekennzeichnet, daß die Partikel solche aus Metall und/oder Keramik sind und/oder daß die Partikel über Metallbrücken, beispielsweise Kupferbrücken miteinander verbunden sind, beispielsweise über durch DCB-Bonden hergestellte Kupferbrücken.

Eine weitere mögliche Ausführungsform der Erfindung ist dadurch gekennzeichnet daß die kapillare bzw. poröse Struktur zumindest in einem Teilbereich von einer losen Schüttung aus Partikeln in einem Raum gebildet ist, der durch eine Zwischenwand vom Flüssigkeitsraum getrennt ist., wobei die Zwischenwand beispielsweise eine Vielzahl von Öffnungen aufweisen kann.

Eine weitere mögliche Ausführungsform der Erfindung ist dadurch gekennzeichnet, daß die kapillare Struktur von wenigstens einer Lage oder Schicht gebildet ist; die zumindest an einem Teil der Innenfläche der den wenigstens einen Innenraum begrenzenden Wandabschnitten aufgebracht ist, und zwar die Pfosten an ihren jeweiligen Verbindungsbereichen mit diesen Wandabschnitten umschließend.

Eine weitere mögliche Ausführungsform der Erfindung ist dadurch gekennzeichnet, daß die die kapillare Struktur bildende Schicht zumindest auf einen Teilbereich der Oberfläche der Pfosten aufgebracht ist,und/oder daß die Pfosten einen Querschnitt aufweisen, der in jeder Querschnittsrichtung wesentlich kleiner ist als die Abmessung des Innenraumes in dieser Querschnittsrichtung.

Eine weitere mögliche Ausführungsform der Erfindung ist dadurch gekennzeichnet, daß zwischen dem Dampfraum und der den wenigstens einen Flüssigkeitskanal bildenden kapillaren Struktur wenigstens eine Zwischenwand vorgesehen ist, wobei beispielsweise die wenigstens eine Zwischenwand mit einer Vielzahl von Öffnungen versehen ist und/oder aus einem perforierten Material besteht und/oder parallel zu den ersten Wandabschnitten liegt und/oder von einem Rohrstück, vorzugsweise von einem flach gedrückten bzw. in einen ovalen Querschnitt verformten Rohrstück gebildet ist.

Eine weitere mögliche Ausführungsform der Erfindung ist dadurch gekennzeichnet, daß wenigstens zwei jeweils einen Flüssigkeitskanal bildende kapillare Strukturen und/oder wenigstens zwei Dampfkanäle vorgesehen sind.

Eine weitere mögliche Ausführungsform der Erfindung ist dadurch gekennzeichnet, daß der erste und zweite Wandabschnitt jeweils von plattenförmigen Wandungen gebildet sind, die zusammen mit einer Umfangswand (5) den Innenraum der Wärmesenke begrenzen.

Eine weitere mögliche Ausführungsform der Erfindung ist dadurch gekennzeichnet, daß die ersten Wandabschnitte von Bereichen eines den Innenraum der Wärmesenke begrenzenden, vorzugsweise flach gedrückten Rohrstückes sind.

Eine weitere mögliche Ausführungsform der Erfindung ist dadurch gekennzeichnet, daß sie aus mehreren, stapelartig übereinander angeordneten und miteinander flächig verbundenen Platten besteht, von denen im Stapel innen liegende Platten mit Öffnungen derart versehen sind, daß durch diese Öffnungen hindurch eine den Innenraum der Wärmesenke bildende Kanalstruktur erhalten ist und sich die strukturierten Platten mit Bereichen außerhalb der Öffnungen zu den durchgehenden Pfosten ergänzen, und daß zumindest in einem Bereich der Kanalstruktur ein die kapillare Struktur bildendes Material eingebracht ist.

Eine weitere mögliche Ausführungsform der Erfindung ist dadurch gekennzeichnet, daß der Innenraum von wenigstens einer Vertiefung oder Ausnehmung in einer die Wärmesenke bildenden Platte gebildet ist.

Eine weitere mögliche Ausführungsform der Erfindung ist dadurch gekennzeichnet, daß die die kapillare Schicht oder Struktur bildenden Partikel einlagig an der betreffenden Fläche der den Innenraum begrenzenden Wandung vorgesehen sind,
wobei beispielsweise die Partikel direkt mit der jeweiligen Fläche verbunden sind, beispielsweise durch DCB-Bonden.

Eine weitere mögliche Ausführungsform der Erfindung ist dadurch gekennzeichnet, daß der Körper der Wärmesenke von einem beidendig verschlossenen Rohrstück gebildet ist.

Entsprechend einer weiteren möglichen Ausführungsform der Erfindung ist ein Verfahren zum Herstellen der Wärmesenke dadurch gekennzeichnet, daß die poröse oder kapillare Struktur durch Einbringen einer Mischung oder Schüttung aus Partikeln aus dem hitzebeständigen Material und pulverförmigem Kupferoxid oder oxidierten Kupfer-Partikeln sowie durch anschließendes DCB-Bonden erzeugt wird.

Entsprechend einer weiteren möglichen Ausführungsform der Erfindung ist ein Verfahren zum Herstellen der Wärmesenke gekennzeichnet durch die Verwendung einer Schüttung oder Mischung, die zusätzlich auch Kupferpartikel enthält.

Entsprechend einer weiteren möglichen Ausführungsform der Erfindung ist ein Verfahren zum Herstellen der Wärmesenke dadurch gekennzeichnet, daß nach dem Bonden und Abkühlen der überschüssige, nicht gebondete Anteil der Schüttung oder Mischung entfernt wird.

Entsprechend einer weiteren möglichen Ausführungsform der Erfindung ist ein Verfahren zum Herstellen der Wärmesenke dadurch gekennzeichnet, daß die kapillare oder poröse Struktur oder Schicht vor dem Verschließen des Innenraumes der Wärmesenke erzeugt wird.

Entsprechend einer weiteren möglichen Ausführungsform der Erfindung ist ein Verfahren zum Herstellen der Wärmesenke dadurch gekennzeichnet, daß die die kapillare Struktur bildende Schüttung oder Mischung durch wenigstens eine Öffnung in den Innenraum eingebracht und dort vor dem Bonden verteilt wird, beispielsweise durch Schütteln, Vibration und/oder Wenden.

Entsprechend einer weiteren möglichen Ausführungsform der Erfindung ist ein Verfahren zum Herstellen der Wärmesenke dadurch gekennzeichnet, daß beim Herstellen der porösen oder kapillaren Struktur zumindest eine einen Dampfraum bildender Teil des Innenraums der Wärmesenke vor dem Bonden der die poröse oder kapillare Struktur bildenden Partikeln durch ein Stützmedium ausgefüllt oder freigehalten wird, wobei beispielsweise das Stützmedium nach dem Bonden bzw. nach der Herstellung der porösen oder kapillaren Struktur entfernt wird oder in der Wärmesenke verbleibt.

Entsprechend einer weiteren möglichen Ausführungsform der Erfindung ist ein Verfahren zum Herstellen der Wärmesenke dadurch gekennzeichnet, daß das Stützmedium ein partikelartiges Medium ist, beispielsweise aus Partikeln aus dem Hitze beständigem Material ohne das Bond-Material besteht.

Entsprechend einer weiteren möglichen Ausführungsform der Erfindung ist ein Verfahren zum Herstellen der Wärmesenke dadurch gekennzeichnet, daß das Stützmedium von einer Wand, beispielsweise von einem diese Wand bildenden Rohrstück gebildet ist.

Sämtliche vorgenannten Ausführungsformen der Erfindung sind jeweils einzeln oder in beliebiger Kombination möglich. Weiterbildungen der Erfindung sind Gegenstand der Unteransprüche. Die Erfindung wird im Folgenden anhand der Figuren an Ausführungsbeispielen näher erläutert. Es zeigen:
- Fig. 1: in vereinfachter Darstellung einen Längsschnitt durch eine Wärmesenke in Form einer Heat-Pipe gemäß der Erfindung;
- Fig. 2: einen Schnitt entsprechend der Linie I - I der Figur 1;
- Fig. 3 und 4: in vergrößerter Darstellung die die poröse Schicht bzw. die Kapillarschicht bildenden Partikel;
- Fig. 5 - 6: Schnittdarstellungen ähnlich der Figur 1 von weiteren möglichen Ausführungsformen der Erfindung;
- Fig. 7: in vereinfachter Teildarstellung und in Seitenansicht eine weitere Ausführung der Erfindung;
- Fig. 8: in vergrößerter Darstellung einen Teilschnitt durch die Wärmesenke der Fig. 7;
- Fig. 9 und 10: in vereinfachter Darstellung Querschnitte durch weitere mögliche Ausführungsformen der Erfindung;
- Fig. 11 bis 14: jeweils einen Längsschnitt (in Teildarstellung) sowie einen Querschnitt zweier weiterer Ausführungen de Erfindung;
- Fig. 15: einen unter Verwendung einer Heat-Pipe hergestellten elektrischen Schaltkreis.

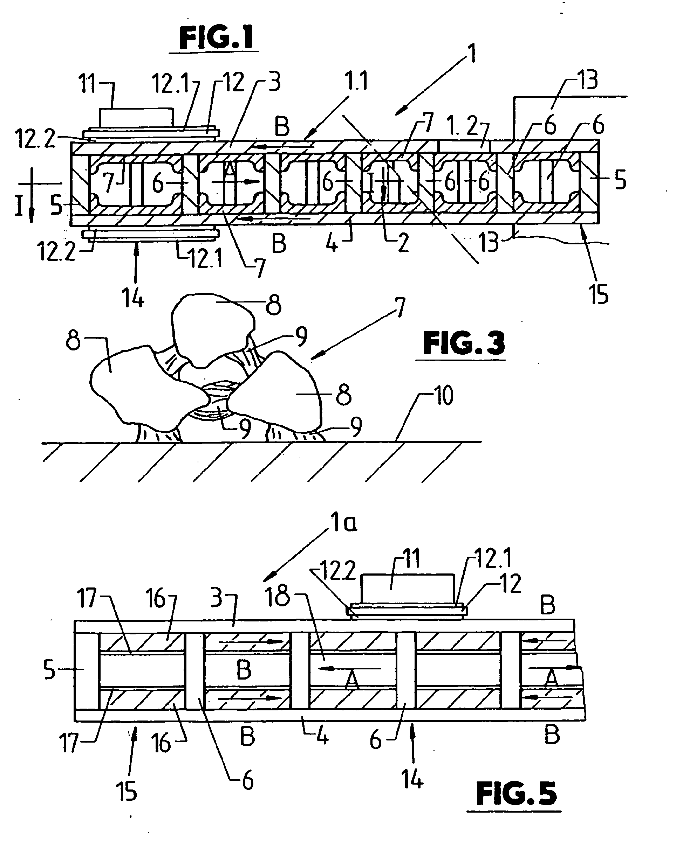

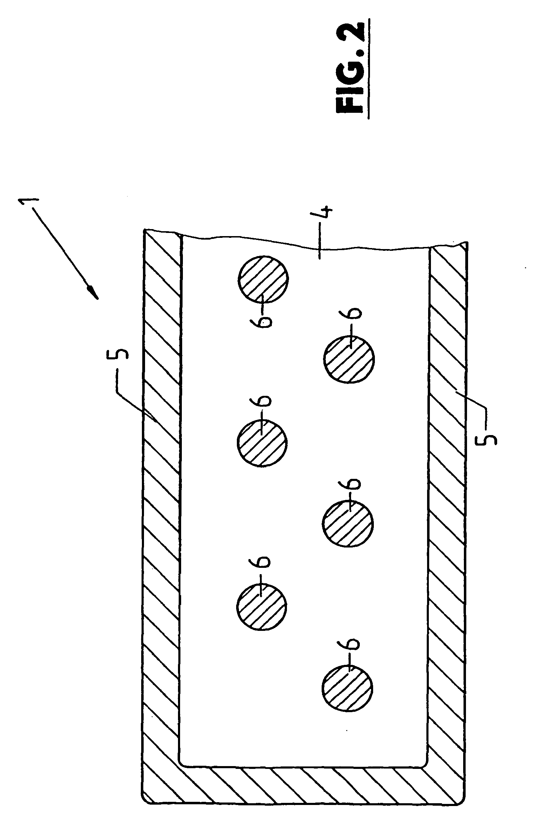

In den Figuren 1 und 2 ist mit 1 allgemein eine als Heat-Pipe ausgebildete Wärmesenke bezeichnet. Diese Wärmesenke 1 ist flach und plattenförmig ausgebildet und besteht hierfür im wesentlichen aus einem flachen, quader- oder plattenförmigen Hohlkörper 1.1, dessen Innenraum 2 an den beiden einander gegenüberliegenden Seiten mit den größeren Flächen durch Wandungen 3 und 4 sowie am Umfang durch eine Umfangswand 5 begrenzt ist. Im Innenraum 2 ist eine Vielzahl von räumlich voneinander beabstandeten Pfosten 6 vorgesehen, die mit ihren Achsen senkrecht zu den Ebenen der Wandungen 3 und 4 liegen und von denen jeder jeweils mit einem Ende unmittelbar mit der Innenfläche der Wandung 3 und mit dem anderen Ende unmittelbar mit der Innenfläche der Wandung 4 verbunden ist.

Die Wandungen 3 und 4 besitzen beispielsweise einen rechteckförmigen oder quadratischen Zuschnitt. Die Pfosten 6 besitzen einen Querschnitt, der jeweils nur ein Bruchteil der Breite sowie Länge des Innenraumes 2 ist, d.h. keiner der Pfosten 6 erstreckt sich über die gesamte Länge oder Breite des Innenraumes 2.

Die Wandungen 3 und 4, die Umfangswand 5 sowie die Pfosten 6 bestehen aus einem Wärme gut leitenden Material, beispielsweise Metall, z.B. aus Kupfer, wobei zum Herstellen der Wärmesenke 1, d. h. zum Verbinden der Wandungen 3 und 4, der Umfangswand 5 und der Pfosten 6 bevorzugt die dem Fachmann bekannte DCB-Technik verwendet ist.

Bei der dargestellten Ausführungsform sind die Innenflächen der Wandungen 3 und 4, teilweise auch die Innenfläche der Umfangswand 5 wie die Pfosten 6 mit einer einen Kapillarraum oder eine Kapillarschicht bildenden porösen Schicht 7 versehen. Diese besteht entsprechend der Figur 3 aus einer Vielzahl von Partikeln 8, die in geeigneter Weise miteinander sowie auch mit der jeweils benachbarten Oberfläche 10 beispielsweise der Wandungen 3 und 4, der Umfangswand 5 und der Pfosten 6 verbunden sind. Die Partikel 8 sind beispielsweise solche aus Aluminiumoxid, Aluminiumnitrid und/oder Siliziumnitrid die unter Verwendung von Kupfer bzw. Kupferbrücken oder -stege 9 miteinander sowie mit der angrenzenden, die Schicht 7 tragenden Fläche 10 verbunden sind. Die Partikel 8 besitzen beispielsweise eine Korngröße zwischen 0,5 bis 250 µm. Bei der Ausführung der Figur 3 bilden die Partikel 8 zwei Lagen oder Reihen. Es ist aber auch möglich, die Partikel 8 nur einlagig auf der Fläche 10 vorzusehen.

Das Aufbringen der Schicht 7 erfolgt beispielsweise so, daß nach dem Herstellen des Hohlkörpers 1.1 über wenigstens eine Befüllungsöffnung 1.2 in den Innenraum 2 eine Mischung oder Schüttung aus den Partikeln 8 und einem pulverförmigen Kupferoxid eingebracht wird, gegebenenfalls auch mit Zusatz von Kupferpulver. Anschließend erfolgt ein Erhitzen des Hohlkörpers auf eine Temperatur, bei der das Kupfer/Kupferoxid-Eutektikum in Schmelze übergeht, d. h. auf eine Temperatur im Bereich zwischen 1065 und 1085°C, so daß durch das Aufschmelzen des Kupfer/Kupferoxid-Eutektikums die die Partikel 8 miteinander sowie mit der die Schicht 7 tragenden Fläche 10 verbindenden Kupferbrücken 9 gebildet werden. Durch entsprechendes Bewegen, beispielsweise Schütteln des Hohlkörpers wird erreicht, daß sich die Schicht 7 in der gewünschten Weise an sämtlichen erforderlichen Innenflächen des Hohlraumes 2 ausbildet. Nach dem Abkühlen des Hohlkörpers und damit nach dem Bonden der die Schicht 7 werden die nicht gebondeten Partikel 8 aus dem Innenraum 2 entfernt.

Grundsätzlich besteht auch die Möglichkeit, anstelle einer Mischung aus den Partikeln 8, dem Kupferpulver und dem Kupferoxid-Pulver bereits mit Kupfer beschichtete Partikel 8 zu verwenden, wobei diese die Partikel 8 umschließende Kupferschicht an der Außenfläche oxidiert ist, so daß sich beim Erhitzen auf die Bond-Temperatur von 1065 bis 1085°C wiederum die Kupferbrücken 9 ausbilden.

Vorstehend wurde im Zusammenhang mit der Figur 3 bereits erwähnt, daß die Partikel 8 zur Bildung der Schicht 7 mehrlagig oder mehrreihig auf der Fläche 10 vorgesehen sein können, d.h. die Dicke der Schicht 7 ist dann bei einlagiger Anordnung der Partikeln 8 auf der Fläche 10 etwa gleich der Korngröße dieser Partikel und bei einer mehrlagigen Anordnung gleich oder etwa gleich einem Mehrfachen der Korngröße der Partikel 8.

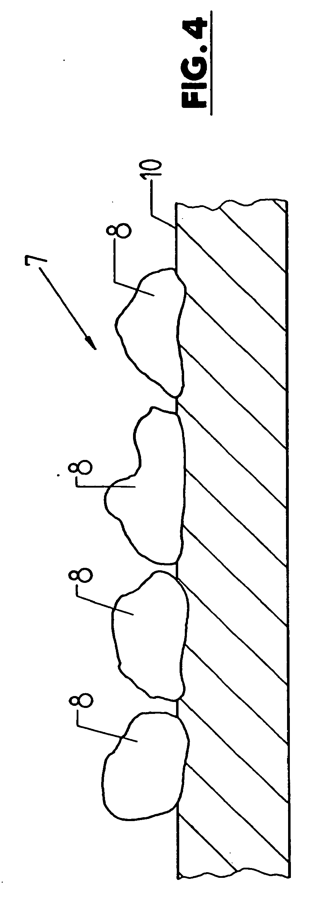

Die Figur 4 zeigt als weitere mögliche Ausführungsform eine Ausbildung der porösen Schicht 7 in der Weise, daß die Partikel 8 durch DCB-Bonden direkt mit der Fläche 10 verbunden sind, eine Verbindung der Partikel 8 untereinander nicht besteht, d.h. die entsprechenden Kupferstege oder -brücken 9 sind nicht vorhanden. Hierdurch wird durch die poröse Schicht 7 eine Struktur erreicht, in der die Partikel 8 einlagig vorgesehen sind, sich aber zwischen den Partikeln 8 eine sehr ausgeprägte kapillare Struktur ergibt, bei der durch Wahl der Korngröße der Partikel 8 der wirksame Querschnitt der Kapillaren eingestellt werden kann.

Weiterhin besteht auch die Möglichkeit, die Schicht 7 zu erzeugen, bevor die Wärmesenke 1 bzw. der diese Wärmesenke bildende Hohlkörper verschlossen wird. In diesem Fall wird beispielsweise die obere Wandung 3 erst dann mit der Umfangswand 5 und dem Pfosten 6 verbunden, nachdem die Schicht 7 an der Innenfläche der unteren Wandung 6 und gegebenenfalls auch an einem Teil der Innenfläche der Umfangswand 5 und an einem Teil der Höhe der Pfosten 6 vorgesehen wurde.

Nach dem Fertigstellen der Schicht 7 wird über die Öffnung 1.2 in den Innenraum 2 ein leicht verdampfbares, Wärme transportierendes Medium eingebracht, und anschließend der Innenraum 2 an der Öffnung 1.2 vollständig verschlossen.

In der Figur 1 ist mit 11 ein Verlustwärme erzeugendes elektrisches Leistungsbauteil bezeichnet, welches auf der Oberseite der Wärmesenke 1, d. h. auf der Außenfläche der Wandung 3 vorgesehen ist, und zwar durch eine Schicht 12 aus einem elektrisch isolierenden Material, beispielsweise aus Keramik, elektrisch getrennt von der Wandung 3. Die Schicht 12 weist strukturierte Metallisierungen 12.1 und 12.2 auf, von denen die Metallisierung 12.1 Leiterbahnen, Kontaktflächen usw. bildet und die Metallisierung 12.2 zur Verbindung mit der Wärmesenke dient. Aus Symmetriegründen ist auf der Unterseite der Wärmesenke 1, d. h. auf der Außenfläche der Wandung 4 ebenfalls eine der Schicht 12 entsprechende Schicht mit Metallisierungen flächig aufgebracht, und zwar beide Schichten 12 beispielsweise unter Verwendung der DCB-Technik.

Bei der dargestellten Ausführungsform befindet sich das Bauteil 11 an einer Schmalseite der in Draufsicht rechteckförmigen Wärmesenke 1. An der gegenüberliegenden Schmalseite der Wärmesenke sind an der Oberseite und an der Unterseite Kühler 13 vorgesehen, die beispielsweise jeweils von einem passiven Kühlelement gebildet oder aber aktive Kühler sind, welche von einem Wärme transportierenden Medium durchströmt werden und Bestandteil eines Kühlkreislaufs sind.

Die von dem Bauteil 11 abgegebene Verlustwärme führt im Bereich dieses Bauteils bzw. an dem in der Figur 1 allgemein mit 14 bezeichneten Verdampfungsbereich zu einem Verdampfen des Wärme transportierenden Mediums im Innenraum 2. Im Bereich der Kühler 13, d. h. an dem in der Figur 1 allgemein mit 15 bezeichneten Kondensationsbereich erfolgt durch Abkühlen ein Kondensieren des Wärme transportierenden Mediums, welches dann innerhalb der Schichten 7 wieder in der flüssigen Phase an den Verdampfungsbereich 14 zurückfließt. Hierdurch erfolgt im Inneren der Wärmesenke ein Kreislauf, und zwar in dem von den Schichten 7 nicht eingenommenen Bereich des Innenraumes 2, der (Bereich) auch als Dampfraum oder Dampfkanal bezeichnet werden kann, eine Strömung des verdampften Wärme transportierenden Mediums in Richtung des Pfeils A vom Verdampfungsbereich 14 an den Kondensationsbereich 15 parallel zu den Ebenen der Wandungen 3 und 4 und innerhalb der Schichten 7 bzw. innerhalb des von diesen Schichten gebildeten Kapillarraumes in Richtung der Pfeile B von dem Kondensationsbereich 15 zurück an den Verdampfungsbereich 14, und zwar wiederum parallel zu den Ebenen der Wandungen 3 und 4.

Durch die Pfosten 6, die jeweils unmittelbar mit den Wandungen 3 und 4 verbunden sind, wird eine hohe Festigkeit, insbesondere auch Druckfestigkeit für die Wärmesenke 1 erreicht. Weiterhin wird eine optimale Wärmeübertragung zwischen der Oberseite (Wandung 3) und Unterseite (Wandung 4) und damit eine optimale Arbeitsweise dieser Wärmesenke erreicht.

Die Figur 5 zeigt in vereinfachter Schnittdarstellung eine als Heat-Pipe ausgebildete Wärmesenke 1a, die sich von der Wärmesenke 1 im wesentlichen dadurch unterscheidet, daß anstelle der von den Schichten 7 gebildeten Flüssigkeitskanälen entlang der oberen Wandung 3 sowie der unteren Wandung 4 jeweils ein Flüssigkeitskanal 16 vorgesehen ist, der jeweils durch eine Wandung 17 von den zwischen den beiden Flüssigkeitskanälen 16 bzw. zwischen den beiden Wandungen 17 gebildeten Dampfkanal 18 getrennt ist. Die obere und untere Wandung 3 und 4 sind wiederum unmittelbar mit mehreren, räumlich voneinander getrennten Pfosten 6 miteinander verbunden, die auch durch die Zwischenwände 17 hindurchreichen und sich jeweils mit einer Teillänge innerhalb der beiden Flüssigkeitskanäle 16 erstrecken. Als Material für die Zwischenwände eignet sich ein perforiertes Flachmaterial, beispielsweise eine perforierte Metallplatte oder -folie, beispielsweise eine perforierte Platte oder Folie aus Kupfer. Für die Zwischenwand 17 können aber auch andere Materialien verwendet werden, beispielsweise ein gitterartiges Flachmaterial oder ein Streckmetall-Material bzw. -metall usw.

Die Zwischenwände 17 sind parallel zur oberen und unteren Wandung 3 bzw. 4 und von dieser jeweils beabstandet vorgesehen. Die Flüssigkeitskanäle sind wiederum mit einem porösen, kapillarartig wirkenden Material ausgefüllt, und zwar beispielsweise mit den Partikeln 8 z. B. aus Aluminiumoxid, wobei diese Partikel 8 auch in den Flüssigkeitskanälen 16 über die Kupferstege 9 miteinander sowie mit den Innenflächen des jeweiligen Flüssigkeitskanals 16 verbunden sind, so daß hierdurch auch eine Verbindung zwischen den äußeren Wandungen 3 und 4 und der jeweiligen Zwischenwand 17 zumindest über die an den Pfosten 6 und den Zwischenwänden 17 gebondeten Partikel 8 erreicht ist.

Die Wärmesenke 1a bzw. deren Hohlkörper werden beispielsweise wiederum unter Anwendung der DCB-Technik hergestellt, wobei für die Realisierung der Flüssigkeitskanäle 16 in die diese Kanäle bildenden Ausnehmungen beispielsweise die Mischung aus den Partikeln 8 und Kupferoxidpulver, gegebenenfalls mit zusätzlichem pulverförmigen Kupfer eingebracht und dann auf die Bond-Temperatur im Bereich zwischen 1065 - 1085° erhitzt wird. Überschüssiges, nicht gebondetes Material wird dann wieder entfernt.

Bei der Ausführung der Figur 5 befindet sich das die Verlustwärme erzeugende elektrische Bauelement 11 nicht an einer Schmalseite des wiederum quaderförmig oder als flache Platte ausgebildeten Wärmesenke 1a, sondern etwa in der Mitte dieser Wärmesenke, wobei an beiden Enden der Wärmesenke jeweils den Kühlern 13 entsprechende Kühler vorgesehen sind. Es ergeben sich somit im Inneren der Wärmesenke 1a zwei Kreisläufe für das Wärme transportierende Medium, und zwar entsprechend den Pfeilen A zwei Dampfströme, die in dem Dampfkanal 18 von dem in der Mitte der Wärmesenke 1a vorgesehenen Verdampfungsbereich 14 jeweils zu einem Ende der Wärmesenke 1a bzw. an jeweils einen Kondensationsbereich 15 verlaufen, und in den Flüssigkeitskanälen 16 die Flüssigkeitsströme entsprechend den Pfeilen B, die von jedem Kondensationsbereichen 15 zurück an den Verdampfungsbereich 14 verlaufen.

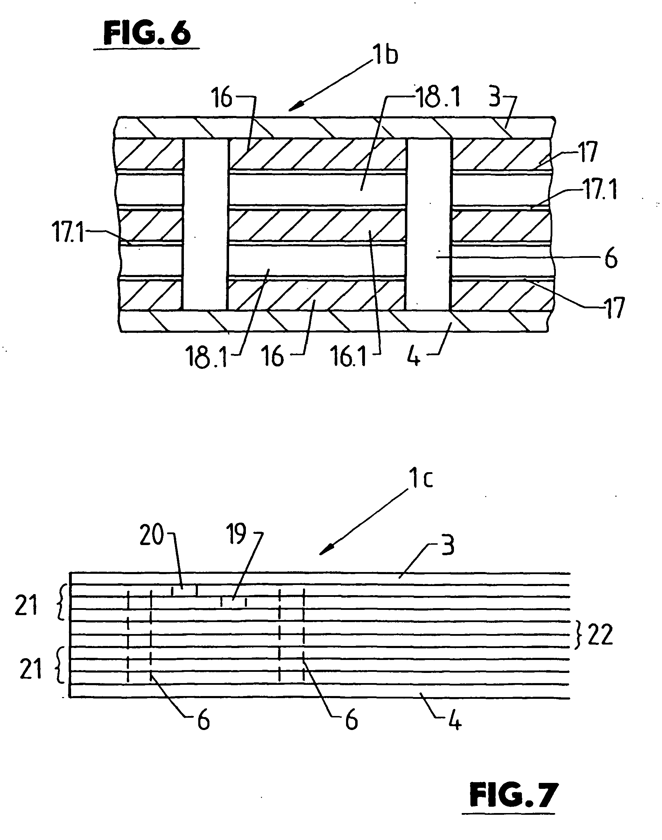

Die Figur 6 zeigt eine als flache, plattenförmige Heat-Pipe ausgebildete Wärmesenke 1b, die sich von der Wärmesenke 1a lediglich dadurch unterscheidet, daß der Dampfkanal 18 der Wärmesenke 1a durch einen weiteren, parallel zu der Ober- und Unterseite der Wärmesenke 1b verlaufenden Flüssigkeitskanal 16.1 in zwei Dampfkanäle 18.1 unterteilt ist. Die Pfosten 6 erstrecken sich auch durch diesen zusätzlichen Flüssigkeitskanal 16.1 hindurch. Die beiden Dampfkanäle 18.1 sind dann jeweils durch eine Zwischenwand 17 des benachbarten Dampfkanals 16 und eine Zwischenwand 17.1 des benachbarten Dampfkanals 16.1 begrenzt. Die Zwischenwände 17.1, die wiederum parallel zu der Ebene der oberen Wandung 3 und der unteren Wandung 4 liegen, bestehen ebenfalls aus dem perforierten Flachmaterial.

Die Figur 7 zeigt in einer sehr schematischen Schnittdarstellung eine weitere, als flache Heat-Pipe ausgebildete Wärmesenke 1c, die zwischen der oberen Wandung 3 und der unteren Wandung 4 aus einer Vielzahl von stapelartig aneinander anschließenden und flächig miteinander verbundenen Platten 19 besteht.

Die Platten 19 sind derart strukturiert bzw. perforiert, d. h. mit Öffnungen versehen, daß sich innerhalb von den Platten 19 gebildeten Volumens der Wärmesenke 1c durch die Öffnungen 20 der Platten hindurch eine Vielzahl von Strömungswegen ergibt. Weiterhin sind die Platten 19 so strukturiert, daß sich die Platten 19 in Bereichen außerhalb der Öffnungen 20 zu durchgehenden Pfosten 6 ergänzen, die sich wiederum zwischen der oberen Wandung 3 und der unteren Wandung 4 erstrecken. Die Platten 19 sind solche aus einem Wärme gut leitenden Material, beispielsweise aus Metall und dabei z. B. aus Kupfer. Die Platten 19 sind mit Hilfe der DCB-Technik oder mit einem Lötverfahren flächig miteinander verbunden.

Geeignete Strukturierungen für die Platten 19 sind z. B. in der DE 197 10 783 A1 beschrieben. Die Öffnungen 20 bzw. die von diesen Öffnungen gebildeten Strömungskanäle sind bei der in der Figur 7 dargestellten Ausführungsform in einem der oberen Wandung 3 und in einem der unteren Wandung 4 benachbarten Bereich 21 jeweils mit dem kapillaren Material ausgefüllt, welches beispielsweise wiederum von den über die Kupferstege 9 miteinander sowie mit angrenzenden Flächen der Platten 19 verbundenen Partikeln 8 gebildet ist. Die Bereiche 21 bilden dann die Flüssigkeitskanäle für das Wärme transportierende Medium. In einem mittleren Bereich 22 bilden die Öffnungen 20 der dortigen Platten 19 ohne die Partikel 8 einen Dampfkanal für das verdampfte, Wärme transportierende Medium.

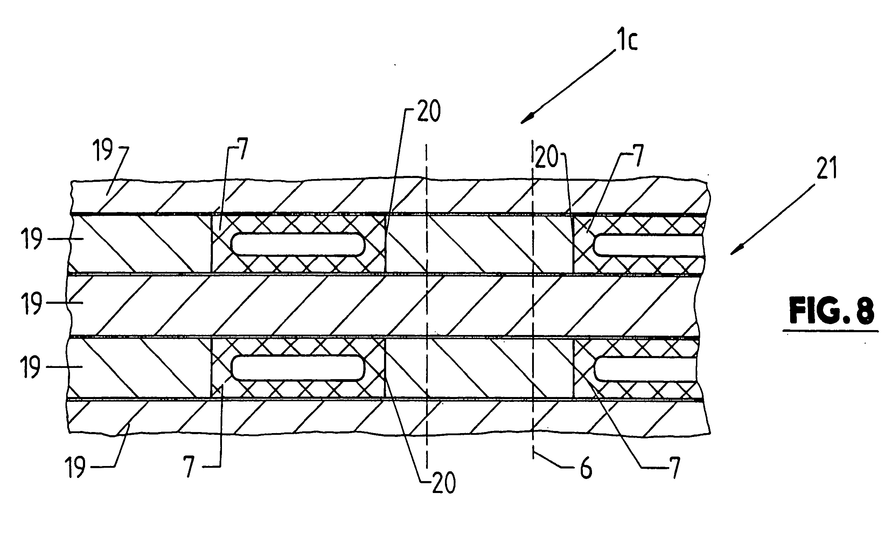

Durch die Öffnungen 20 bzw. durch die von diesen Öffnungen erzeugte Strukturierung bilden die Platten 19 nicht nur die durchgehenden Pfosten 6, sondern auch zwischen diesen Pfosten sich erstreckende Stege 19.1 innerhalb der Flüssigkeitskanäle für das Wärme transportierende Medium, wobei beispielsweise die jeweils von einer Platte 19 gebildeten Stege 19.1 Öffnungen 20 in benachbarten Platten 19 gegenüberliegen, wie dies in der Figur 8 schematisch dargestellt ist. In dieser Figur ist mit 7 wiederum die poröse oder kapillare Schicht beispielsweise aus den Partikeln 8 angegeben. Diese Schicht bedeckt bei dieser Ausführungsform in den Bereichen 21 bzw. an den dortigen Platten 19 sämtliche in den Flüssigkeitskanälen freiliegenden Flächen.

Es versteht sich, daß in Abwandlung der Wärmesenke 1c auch mehrere Flüssigkeitskanäle bildende Bereiche 21 vorgesehen sein können, und zwar jeweils abwechselnd mit einem einen Dampfkanal bildenden Bereich 22.

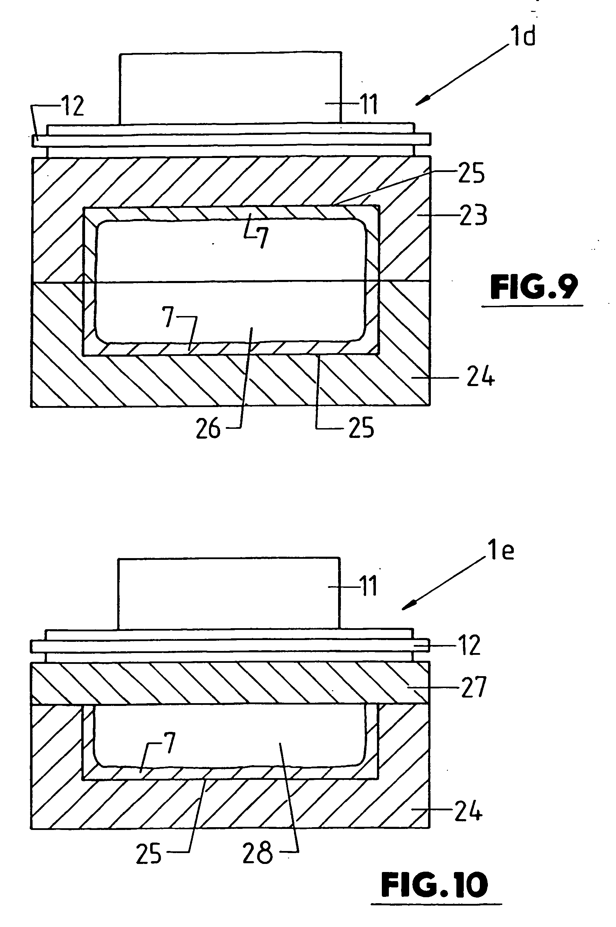

Die Figur 9 zeigt in einem Querschnitt senkrecht zur Strömungs- bzw. Fließrichtung des Wärme transportierenden Mediums eine Wärmesenke 1d. Diese besteht aus zwei Platten 23 und 24 aus einem Wärme gut leitenden Material, beispielsweise aus Kupfer, die an einer Oberflächenseite flächig miteinander verbunden sind. In jeder Platte ist eine muldenförmige Vertiefung oder Ausnehmung 25 eingebracht. Beide Ausnehmungen 25 ergänzen sich bei miteinander verbundenen Platten 23 und 24 zu einem geschlossenen, lang gestreckten Kanal 26 innerhalb des von den Platten 23 und 24 gebildeten Körpers der Wärmesenke 1d. Die Innenflächen des Kanals 26 sind mit der kapillaren Schicht 7 versehen, so daß sich innerhalb dieser Schicht der Flüssigkeitskanal und in dem von der Schicht 7 nicht eingenommenen Raum des Kanals 26 der Dampfkanal ergeben.

Die Figur 10 zeigt als Abwandlung der Figur 9 eine als flache Heat-Pipe ausgebildete Wärmesenke 1e, bei der wiederum die Platte 24 mit der Ausnehmung 25 verwendet ist, anstelle der Platte 23 aber eine Platte 27 ohne Ausnehmung. Die Platte 27 ist mit der die Ausnehmung 25 aufweisenden Seite der Platte 24 flächig verbunden, so daß sich der dem Kanal 26 entsprechende geschlossene Kanal 28 ergibt. Flächen der Ausnehmung 25 sind wiederum mit der Schicht 7 versehen. Die Platte 27 ist beispielsweise eine Metallplatte, z.B. eine Kupferplatte oder Kupferfolie. Grundsätzlich besteht auch die Möglichkeit, die Platte 27 aus einem elektrisch isolierenden Material zu fertigen, beispielsweise aus Keramik, z. B. aus einer Aluminiumoxid- oder Aluminiumnitrid-Keramik.

Das zu kühlende Bauelement 11 ist bei den Wärmesenken 1d und 1e jeweils an einem dem Kanal 26 bzw. 28 unmittelbar benachbarten Bereich der Außenfläche der Wärmesenke vorgesehen, und zwar wiederum gegenüber dem Körper der Wärmesenke 1d bzw. 1e elektrisch isoliert auf der mit den elektrischen Kontaktflächen versehenen Isolierschicht 12.

Ist bei der Wärmesenke 1e die Platte 27 aus einem elektrisch isolierenden Material, nämlich aus Keramik gefertigt, so können die Leiterbahnen und/oder Kontaktflächen für das Bauteil 11 unmittelbar auf der dem Kanal 28 abgewandten Oberflächenseite der Platte 27 vorgesehen werden.

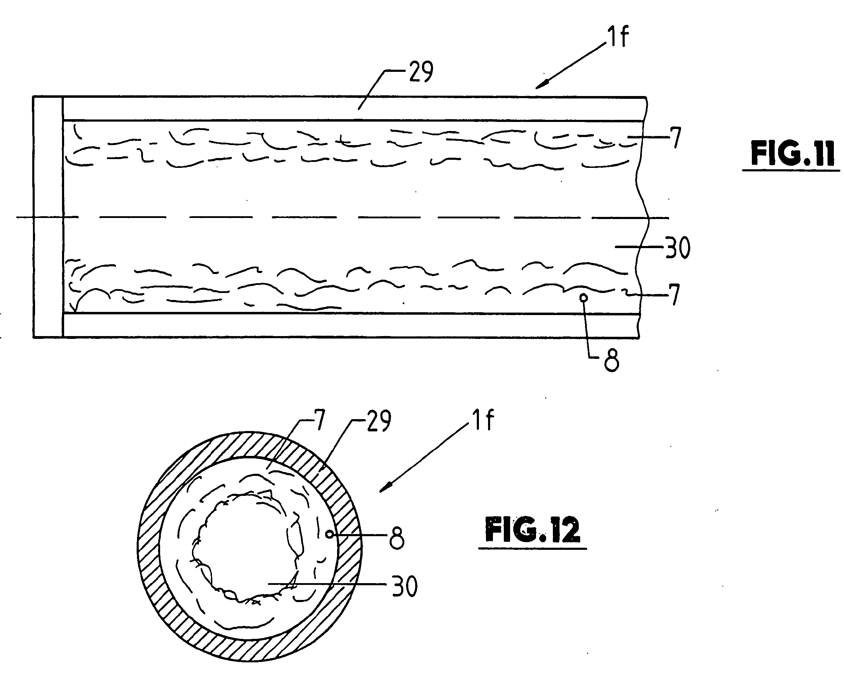

Die Figuren 11 und 12 zeigen als weitere mögliche Ausführungsform eine als Heat-Pipe ausgebildete Wärmesenke, deren Hohlkörper von einem beidendig verschlossenen Rohrstück 29 besteht, welches aus einem Material mit hoher Wärmeleitfähigkeit, beispielsweise aus Kupfer gefertigt ist. Bei der dargestellten Ausführungsform besitzt das Rohrstück 29 einen kreiszylinderförmigen Innen- und Außenquerschnitt. Grundsätzlich besteht auch die Möglichkeit, die Wärmesenke 1f flach auszubilden, und zwar durch entsprechendes Flachdrücken des Rohrstückes 29 in einen ovalen Querschnitt.

An der Innenfläche des Rohrstückes 29 ist die poröse bzw. kapillare Schicht 7 ausgebildet. Die Herstellung erfolgt dabei in der Weise, daß in das Rohrstück 29 das die Schicht 7 bildende Material eingebracht wird, beispielsweise die Mischung bestehend aus den Partikeln 8 und pulverförmigem Kupferoxid und Kupfer. Das die Schicht 7 bildende Material wird dabei so eingebracht, daß es eine ring- oder hohlzylinderförmige, gegen die Innenfläche des Rohrstückes 29 anliegende erste Schüttung bildet. Weiter innen liegend und bei dieser Ausführung von der ersten Schüttung umgeben ist Stützmedium 30, beispielsweise in Form einer zweiten Schüttung aus einem geeigneten, partikelartigen Material vorgesehen, beispielsweise aus Partikeln aus Keramik ohne den Zusatz von Kupferoxid sowie Kupfer.

Nach dem Erhitzen der Anordnung auf die Bond-Temperatur und nach dem anschließenden Abkühlen sind lediglich die Partikel 8 der ersten Schüttung durch die Kupferbrücken oder Kupferstege 9 mit der Innenfläche des Rohrstückes 29 sowie miteinander zu der porösen Schicht 7 verbunden, während die Partikel, die die zweite Schüttung bzw. das Stützmedium 30 bilden, nach dem Bonden entfernt werden können.

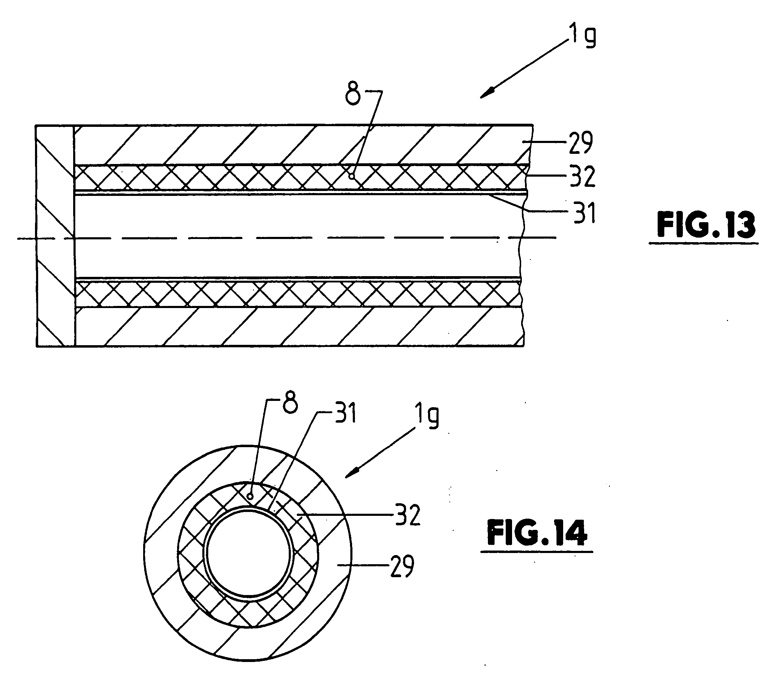

Die Figuren 13 und 14 zeigen als weitere mögliche Ausführungsform eine als Heat-Pipe ausgebildete Wärmesenke 1g. Auch bei dieser Wärmesenke 1g ist der Hohlkörper wiederum von dem beidendig verschlossenen Rohrstück 29 aus dem Wärme gut leitenden Material, beispielsweise aus Kupfer gebildet. In dem Rohrstück 29 ist ein weiteres Rohrstück 31 aus einem perforierten oder siebartigen Material vorgesehen, und zwar derart, daß sich zwischen der Außenfläche des Rohrstückes 31 und der Innenfläche des Rohrstückes 29 ein Ringraum 32 ergibt. Dieser bildet bei dieser Wärmesenke 1g den Flüssigkeitskanal. Der Innenraum des Rohrstückes 31 bildet den Dampfkanal. Der Ringraum 32 ist mit einer Schüttung aus den Partikeln 8 und/oder aus entsprechenden, eine kapillare Struktur bildenden Partikeln ausgefüllt, die dann entweder durch Bonden oder Sintern miteinander sowie ggf. auch mit der Innenfläche des Rohrstückes 29 und der Außenfläche des Rohrstückes 31 verbunden sind, und zwar beispielsweise wieder über die Kupferstege 9 oder aber über entsprechende Metall- oder Kupferstege. Grundsätzlich besteht auch die Möglichkeit, daß der Ringraum 32 die poröse bzw. kapillarartige Struktur bildenden Partikel als lose Schüttung enthält. Das Rohrstück 31 ist beispielsweise perforiert, d.h. mit einer Vielzahl von Öffnungen versehen oder aber aus einem perforierten Flachmaterial hergestellt, und zwar aus einem Material mit hoher Wärmeleitfähigkeit, beispielsweise aus Metall, z.B. aus Kupfer. Auch andere Materialien sind für das Rohrstück 31 denkbar, beispielsweise auch gitterartige, gewebartige Materialien oder Streckmetalle. Weiterhin besteht auch die Möglichkeit, das Rohrstück 31 lediglich als Stützkörper während der Fertigung, d.h. beim Bonden der im Ringraum 32 aufgenommenen Partikel 8 zu verwenden und nach dem Bonden wieder zu entfernen.

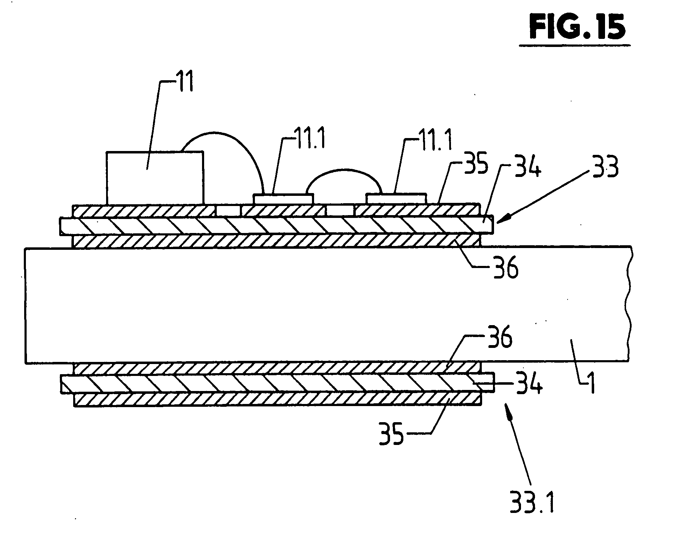

Die Figur 15 zeigt in vereinfachter Darstellung die Verwendung der erfindungsgemäßen Wärmesenke bzw. Heat-Pipe bei einer elektrischen Schaltung. Die Wärmesenke ist in der Figur 15 mit 1 bezeichnet. Es versteht sich, daß bei dieser Anwendung auch jede andere Wärmesenke gemäß der Erfindung Verwendung finden kann, beispielsweise auch eine der Wärmesenken 1a - 1 g.

Auf der Oberseite der flachen Wärmesenke 1 ist als Basis für die elektrischen Bauelemente, die in dieser Figur mit 11 und 11.1 bezeichnet sind, ein Kupfer-Keramik-Substrat 33 aufgebracht. Dieses besteht aus einer Keramikschicht 34, die beidseitig mit jeweils einer Kupferschicht bzw. Kupferfolie 35 und 36 versehen ist, und zwar vorzugsweise unter Anwendung der DCB-Technik. Mit der Kupferschicht 36 ist das Substrat 33 flächig mit der Oberseite der Wärmesenke 1 verbunden, beispielsweise durch Auflöten oder auf eine andere geeignete Weise. Die der Wärmesenke 1 abgewandte Kupferschicht 35 ist zur Bildung von Leiterbahnen, Kontaktflächen usw. strukturiert. Auf durch diese Strukturierung gebildeten Flächen sind die Bauelemente 11 und 11.1 befestigt, beispielsweise aufgelötet, wobei das Bauelement 11 ein Leistungsbauelement ist und die Bauelemente 11.1 beispielsweise ansteuernde Bauelemente sind.

Bei der Ausführung der Figur 15 befindet sich das Substrat 33 mit den Bauelementen 11 und 11.1 im Bereich einer Schmalseite der langgestreckten Wärmesenke 1. Im Bereich der anderen Schmalseite sind die Kühler 13 vorgesehen. Aus Gründen der Symmetrie und zur Vermeidung eines Bimetall-Effektes bzw. einer Verformung der Anordnung bei Temperaturänderungen ist auch auf der Unterseite der Wärmesenke 1 ein dem Substrat 33 entsprechendes Substrat 33.1 aufgebracht, allerdings ohne die Bauelemente 11 und 11.1.

Die Erfindung wurde voranstehend an mehreren Ausführungsbeispielen beschrieben. Es versteht sich, daß weitere Änderungen sowie Abwandlungen möglich sind, ohne daß dadurch der der Erfindung tragende Gedanke verlassen wird. So ist es beispielsweise möglich, Bauelemente auf beiden Seiten der flachen bzw. plattenförmigen Wärmesenke vorzusehen, z. B. bei der Ausführung der Figur 15 auch auf dem weiteren Substrat 33.1.

Weiterhin ist es möglich, für die Herstellung der porösen, kapillaren Struktur auch andere Materialien zu verwenden, beispielsweise Partikel aus einer anderen Keramik oder aus einem anderen geeigneten Material, z. B. Siliziumoxid. Weiterhin ist es auch möglich, diese Strukturen z. B. durch Sintern eines geeigneten Materials, beispielsweise auch eines geeigneten Metalls zu fertigen.

Abweichend von der im Zusammenhang mit den Figuren 11 und 12 beschriebenen Herstellungsmethode ist es auch möglich, bei der Herstellung der Wärmesenke 1f in das beispielsweise zumindest an der Innenfläche oxidierte Rohrstück 29 aus Metall, beispielsweise aus Kupfer, die Partikel 8 aus Keramik oder einen anderen Hitze beständigen Material als eine den Innenraum des Rohrstückes 29 vollständig ausfüllende Schüttung einzubringen und dann die Anordnung auf die Bonde-Temperatur im Bereich zwischen 1065 - 1085°C zu erhitzen und die Anordnung anschließend abzukühlen. Die außenliegenden, d.h. gegen die Innenfläche des Rohrstückes anliegenden Partikel sind dann mit der Innenfläche des Rohrstückes 29 verbunden. Der Rest der Schüttung kann dann aus dem Rohrstück 29 entfernt werden, so daß sich eine poröse, kapillarartige Struktur in Form einer einlagigen Schicht 7 ausgebildet hat.

Weiterhin wurde vorstehend bei der Darstellung der Figur 8 davon ausgegangen, daß bei der Wärmesenke 1c die die Strömungskanäle bildenden Öffnungen jeweils nur teilweise mit der porösen bzw. kapillaren Schicht 7 oder den diese Schicht bildenden Partikeln 8 ausgefüllt sind. Selbstverständlich ist es auch möglich, die Öffnungen bzw. die von diesen gebildeten Strömungskanäle in den Bereichen 21 vollständig mit den Partikeln 8 auszufüllen.

### Bezugszeichenliste

- 1 - 1 g: Wärmesenke bzw. Heat-Pipe
- 1.1: Hohlkörper
- 1.2: Öffnung
- 2: Innenraum
- 3, 4: obere und untere Wandung der flachen Heat-Pipe
- 5: Umfangswand
- 6: Pfosten
- 7: poröse bzw. kapillare Schicht
- 8: Partikel
- 9: Kupfersteg
- 10: Fläche
- 11, 11.1: Bauteil bzw. Bauelement
- 12: Isolierschicht mit strukturierter Metallisierung
- 12.1, 12.2: Metallisierung
- 13: Kühler
- 14: Verdampfungsbereich
- 15: Kondensationsbereich
- 16: Flüssigkeitskanal
- 17, 17.1: Zwischenwand
- 18, 18a: Dampfkanal
- 19: Platte bzw. Folie
- 20: Öffnung
- 21, 22: Bereich der Wärmesenke 1 c
- 23, 24: Platte
- 25: Ausnehmung
- 26: Kanal
- 27: Platte
- 28: Kanal
- 29: Rohrstück
- 30: Stützmedium
- 31: Rohrstück
- 32: Ringraum
- 33, 33.1: Metall-Keramik-Substrat, beispielsweise Kupfer-Keramik-Substrat
- 34: Keramikschicht
- 35, 36: Metallschicht, beispielsweise Kupferschicht

## Patentansprüche

1. Wärmesenke ausgebildet als Heat-Pipe, beispielsweise als flache Heat-Pipe mit wenigstens einem in einem Körper der Wärmesenke ausgebildeten, nach außen verschlossenen Innenraum mit wenigstens einem Dampfkanal oder Dampfraum (18, 18.1), mit wenigstens einem mit dem Dampfkanal (18, 18.1) in Verbindung stehenden und von einer porösen oder kapillare Struktur gebildeten Flüssigkeitsraum oder Flüssigkeitskanal (16), **dadurch gekennzeichnet, dass** die poröse oder kapillare Struktur zumindest teilweise aus Keramikpartikeln gebildet ist.

2. Wärmesenke nach Anspruch 1, **dadurch gekennzeichnet, daß** die kapillare bzw. poröse Struktur aus Partikeln (8) besteht, die durch Bonden oder Sintern derart miteinander und/oder mit einer benachbarten Fläche (10) verbunden sind, daß sich zwischen den Partikeln (8) kapillare Strömungswege ergeben.

3. Wärmesenke nach Anspruch 1 oder 2, **gekennzeichnet durch** mehrere **durch** den Innenraum hindurchreichende und sich zwischen zwei einander gegenüber liegenden, den Innenraum begrenzenden Wandungen oder Wandabschnitten erstreckende und räumlich voneinander getrennte Pfosten (6), wobei die Pfosten (6) sowie die einander gegenüberliegenden Wandabschnitte (3, 4) jeweils aus einem Material hoher Wärmeleitfähigkeit, beispielsweise aus Metall, z.B. aus Kupfer bestehen, und wobei jeder Pfosten (6) beidendig unmittelbar mit einem der einander gegenüberliegenden Wandabschnitte (3, 4) verbunden ist.

4. Wärmesenke nach einem der vorhergehenden Ansprüche, **dadurch gekennzeichnet, daß** die Partikel solche aus Metall und/oder Keramik sind und/oder daß die Partikel (8) über Metallbrücken, beispielsweise Kupferbrücken (9) miteinander verbunden sind, beispielsweise über durch DCB-Bonden hergestellte Kupferbrücken.

5. Wärmesenke nach einem der vorhergehenden Ansprüche, **dadurch gekennzeichnet daß** die kapillare bzw. poröse Struktur zumindest in einem Teilbereich von einer losen Schüttung aus Partikeln (8) in einem Raum (32) gebildet ist, der durch eine Zwischenwand (31) vom Flüssigkeitsraum getrennt ist., wobei die Zwischenwand (31) beispielsweise eine Vielzahl von Öffnungen aufweist.

6. Wärmesenke nach einem der vorhergehenden Ansprüche, **dadurch gekennzeichnet, daß** die kapillare Struktur von wenigstens einer Lage oder Schicht (7) gebildet ist, die zumindest an einem Teil der Innenfläche (10) der den
wenigstens einen Innenraum (2) begrenzenden Wandabschnitten aufgebracht ist, und zwar die Pfosten (6) an ihren jeweiligen Verbindungsbereichen mit diesen Wandabschnitten (3, 4) umschließend,
und/oder
daß die die kapillare Struktur bildende Schicht zumindest auf einen Teilbereich der Oberfläche der Pfosten (6) aufgebracht ist,
und/oder
daß die Pfosten (6) einen Querschnitt ausweisen, der in jeder Querschnittsrichtung wesentlich kleiner ist als die Abmessung des Innenraumes in dieser Querschnittsrichtung.

7. Wärmesenke nach einem der vorhergehenden Ansprüche, **dadurch gekennzeichnet, daß** zwischen dem Dampfraum (18, 18.1) und der den wenigstens einen Flüssigkeitskanal bildenden kapillaren Struktur wenigstens eine Zwischenwand (17, 17.1, 29) vorgesehen ist,
wobei beispielsweise die wenigstens eine Zwischenwand (17, 17.1, 29) mit einer Vielzahl von Öffnungen versehen ist und/oder aus einem perforierten Material besteht und/oder parallel zu den ersten Wandabschnitten (3, 4) liegt und/oder von einem Rohrstück (29), vorzugsweise von einem flach gedrückten bzw. in einen ovalen Querschnitt verformten Rohrstück gebildet ist.

8. Wärmesenke nach einem der vorhergehenden Ansprüche, **dadurch gekennzeichnet, daß** wenigstens zwei jeweils einen Flüssigkeitskanal (16) bildende kapillare Strukturen und/oder wenigstens zwei Dampfkanäle (18, 18.1) vorgesehen sind.

9. Wärmesenke nach einem der vorhergehenden Ansprüche 3 bis 8 **dadurch gekennzeichnet, daß** der erste und zweite Wandabschnitt jeweils von plattenförmigen Wandungen (3, 4) gebildet sind, die zusammen mit einer Umfangswand (5) den Innenraum der Wärmesenke begrenzen, und/oder daß die ersten Wandabschnitte von Bereichen eines den Innenraum der Wärmesenke begrenzenden, vorzugsweise flach gedrückten Rohrstückes sind.

10. Wärmesenke nach Anspruch 3, **dadurch gekennzeichnet, daß** sie aus mehreren, stapelartig übereinander angeordneten und miteinander flächig verbundenen Platten (3, 4, 19) besteht, von denen im Stapel innen liegende Platten mit Öffnungen (20) derart versehen sind, daß durch diese Öffnungen hindurch eine den Innenraum der Wärmesenke bildende Kanalstruktur erhalten ist und sich die strukturierten Platten (19) mit Bereichen außerhalb der Öffnungen (20) zu den durchgehenden Pfosten (6) ergänzen, und daß zumindest in einem Bereich (21) der Kanalstruktur ein die kapillare Struktur bildendes Material eingebracht ist.

11. Wärmesenke nach Anspruch 10, **dadurch gekennzeichnet, daß** der Innenraum (26, 28) von wenigstens einer Vertiefung oder Ausnehmung (25) in einer die Wärmesenke bildenden Platte (23, 24) gebildet ist.

12. Wärmesenke nach einem der vorhergehenden Ansprüche, **dadurch gekennzeichnet, daß** die die kapillare Schicht oder Struktur (7) bildenden Partikel (8) einlagig an der betreffenden Fläche (10) der den Innenraum begrenzenden Wandung vorgesehen sind,
wobei beispielsweise die Partikel (8) direkt mit der jeweiligen Fläche (10) verbunden sind, beispielsweise durch DCB-Bonden.

13. Wärmesenke nach einem der vorhergehenden Ansprüche, **dadurch gekennzeichnet, daß** der Körper der Wärmesenke von einem beidendig verschlossenen Rohrstück (29) gebildet ist.

14. Verfahren zum Herstellen einer als Heat-Pipe ausgebildeten Wärmesenke nach Anspruch 1 mit wenigstens einem in einem geschlossenen Innenraum ausgebildeten Dampfkanal und mit wenigstens einem Flüssigkeitskanal mit einer porösen oder kapillaren Struktur, **dadurch gekennzeichnet,**
**daß** die poröse oder kapillare Struktur durch Einbringen einer Schüttung aus Keramikpartikeln (8) in den Flüssigkeitskanal sowie durch anschließendes DCB-Bonden bei Erhitzen auf eine Bond-Temperatur im Bereich zwischen 1 065 bis 1085°C erzeugt wird.

15. Verfahren nach Anspruch 14, **dadurch gekennzeichnet,**
**daß** die poröse oder kapillare-Struktur durch Einbringen einer Mischung oder Schüttung aus Partikeln in den Flüssigkeitskanal aus dem hitzebeständigen Material und pulverförmigem Kupferoxid oder oxidierten Kupfer-Partikeln sowie durch anschließendes DCB-Bonden erzeugt wird.

16. Verfahren nach Anspruch 14 oder 15, **gekennzeichnet durch** die Verwendung einer Schüttung oder Mischung, die zusätzlich auch Kupferpartikel enthält.

17. Verfahren nach einem der vorhergehenden Ansprüche 14 bis 16, **dadurch gekennzeichnet, daß** nach dem Bonden und Abkühlen der überschüssige, nicht gebondete Anteil der Schüttung oder Mischung entfernt wird.

18. Verfahren nach einem der vorhergehenden Ansprüche 14 bis 17, **dadurch gekennzeichnet, daß** die kapillare oder poröse Struktur oder Schicht vor dem Verschließen des Innenraumes der Wärmesenke erzeugt wird.

19. Verfahren nach einem der vorhergehenden Ansprüche 14 bis 18, **dadurch gekennzeichnet, daß** die die kapillare Struktur bildende Schüttung oder Mischung durch wenigstens eine Öffnung in den Innenraum eingebracht und dort vor dem Bonden verteilt wird, beispielsweise durch Schütteln, Vibration und/oder Wenden.

20. Verfahren nach einem der vorhergehenden Ansprüche 14 bis 19, **dadurch gekennzeichnet, daß** beim Herstellen der porösen oder kapillaren Struktur zumindest eine einen Dampfraum bildender Teil des Innenraums der Wärmesenke vor dem Bonden der die porös oder kapillare Struktur bildenden Partikeln durch ein Stützmedium (30, 31) ausgefüllt oder freigehalten wird,
wobei beispielsweise das Stützmedium (30) nach dem Bonden bzw. nach der Herstellung der porösen oder kapillaren Struktur entfernt wird oder in der Wärmesenke verbleibt.

21. Verfahren nach Anspruch 10 **dadurch gekennzeichnet, daß** das Stützmedium (30) ein partikelartiges Medium ist, beispielsweise aus Partikeln aus dem Hitze beständigem Material ohne das Bond-Material besteht.

22. Verfahren nach einem der vorhergehenden Ansprüche 20 und 21, **dadurch gekennzeichnet, daß** das Stützmedium von einer Wand (31), beispielsweise von einem diese Wand bildenden Rohrstück gebildet ist.

## Claims

1. Heat sink designed as a heat pipe, by way of example a flat heat pipe, having at least one internal chamber formed in a body of the heat sink and closed on the outside and provided with at least one steam channel or steam chamber (18 , 18.1) with at least one fluid chamber or fluid channel (16) which is formed by a porous or capillary structure and is in communication with the steam channel (18, 18.1), **characterised in that** the porous or capillary structure is formed at least in part of ceramic particles.

2. Heat sink according to claim 1 **characterised in that** the capillary or porous structure is made from particles (8) which are joined to one another and/or to an adjoining surface area (10) through bonding or sintering in such a way that capillary flow paths are formed between the particles (8).

3. Heat sink according to claim 1 or 2 **characterised by** several rods (6) which spatially separated from one another extend through the internal chamber between two opposing walls or wall sections which define the internal chamber, wherein the rods (6) as well as the opposing wall sections (3, 4) are each made from a material of higher heat conductivity, by way of example metal, for example, copper, and wherein each rod (6) is connected at each end directly to one of the wall sections (3, 4) which lie opposite one another.

4. Heat sink according to one of the preceding claims **characterised in that** the particles are those of metal and/or ceramic and /or that the particles (8) are joined to one another by metal bridges, by way of example copper bridges (9), by way of example by copper bridges made by DCB bonding.

5. Heat sink according to one of the preceding claims, **characterised in that** the capillary or porous structure is formed in at least one partial area by a loose bulk filling of particles (8) in a chamber (32) which is separated by a partition (31) from the fluid chamber wherein the partition (31) has by way of example a plurality of openings.

6. Heat sink according to one of the preceding claims **characterised in that** the capillary structure is formed by at least one layer or film (7) which is applied to one part of the interior surface area (10) of the wall sections which define the at least one internal chamber (2), namely surrounding the rods (6) at their respective joining areas with these wall sections (3, 4),
and/or
that the film forming the capillary structure is applied at least to a partial area of the surface of the rods (6),
and/or that the rods (6) have a cross-section which in each cross-sectional direction is substantially smaller than the dimension of the internal chamber in this cross-sectional direction.

7. Heat sink according to one of the preceding claims **characterised in that** at least one partition (17, 17.1, 29) is provided between the steam chamber (18, 18.1) and the capillary structure which forms the at least one fluid channel,
wherein by way of example the at least one partition (17, 17.1, 29) is provided with a plurality of openings and/or is made from a perforated material and/or lies parallel to the first wall sections (3, 4) and/or is formed by a pipe member (29), preferably by a pipe member which is pressed flat or is shaped into an oval cross-section.

8. Heat sink according to one of the preceding claims **characterised in that** at least two capillary structures each forming a fluid channel (16) and/or at least two steam channels (18, 18.1) are provided.

9. Heat sink according to one of the preceding claims 3 to 8 **characterised in that** the first and second wall section are each formed by plate-type walls (3, 4) which together with a circumferential wall (5) define the internal chamber of the heat sink, and/or that the first wall sections are from areas of a pipe member, preferably pressed flat, which defines the internal chamber of the heat sink.

10. Heat sink according to claim 3 **characterised in that** it consists of several plates (3, 4, 19) arranged stack-like one above the other and connected to one another over flat surfaces, of which the plates lying on the inside in the stack are provided with openings (20) so that a channel structure forming the internal chamber of the heat sink is created through these openings and the structured plates (19) with areas outside of the openings (20) make up the full-length rods (6), and that a material forming the capillary structure is introduced at least into one area (21) of the channel structure.

11. Heat sink according to claim 10 **characterised in that** the internal chamber (26, 28) is formed by at least one indentation or one recess (25) in one of the plates (23, 24) which form the heat sink.

12. Heat sink according to one of the preceding claims **characterised in that** the particles (8) which form the capillary film or structure (7) are provided in a single layer on the relevant surface area (10) of the wall which defines the internal chamber, wherein by way of example the particles (8) are connected directly to the relevant surface area (10), for example by DCB bonding.

13. Heat sink according to one of the preceding claims **characterised in that** the body of the heat sink is formed by a pipe member (29) which is closed at both ends.

14. Method for manufacturing a heat sink formed as a heat pipe according to claim 1 having at least one steam channel formed in a closed internal chamber and with at least one fluid channel having a porous or capillary structure, **characterised in that** the porous or capillary structure is produced by introducing a loose bulk filling of ceramic particles (8) into the fluid channel and by subsequent DCB bonding through heating to a bonding temperature in the range from between 1065° to 1085°C.

15. Method according to claim 14 **characterised in that** the porous or capillary structure is created by introducing a mixture or loose bulk filling of particles into the fluid channel of the heat-resistant material and powdered copper oxide or oxidized copper particles as well as by subsequent DCB bonding.

16. Method according to claim 14 or 15 **characterised by** the use of a loose bulk filling or mixture which additionally contains also copper particles.

17. Method according to one of the preceding claims 14 to 16 **characterised in that** after the bonding and cooling the excess non-bonded portion of the loose bulk filling or mixture is removed.

18. Method according to one of the preceding claims 14 to 17 **characterised in that** the capillary or porous structure or film is created prior to closing the internal chamber of the heat sink.

19. Method according to one of the preceding claims 14 to 18 **characterised in that** the loose bulk filling or mixture forming the capillary structure is introduced through at least one opening into the internal chamber and is distributed there prior to bonding, by way of example through shaking, vibration and/or turning.

20. Method according to one of the preceding claims 14 to 19 **characterised in that** during production of the porous or capillary structure at least one part of the internal chamber of the heat sink forming a steam chamber is filled out or kept free by a support medium (30, 31) prior to the bonding of the particles which form the porous or capillary structure,
wherein by way of example the support medium (30) after the bonding or after the production of the porous or capillary structure is removed or remains in the heat sink.

21. Method according to claim 10 **characterised in that** the support medium (30) is a particle-like medium, by way of example consists of particles of the heat-resistant material without the bonding material.

22. Method according to one of the preceding claims 20 and 21 **characterised in that** the support medium is formed by a wall (31), by way of example by a pipe member forming this wall.

## Revendications

1. Dissipateur thermique conçu comme un heat-pipe, par exemple comme un heat-pipe plat avec au moins un espace interne fermé vers l'extérieur et conçu dans un corps du dissipateur thermique doté d'au moins un canal de vapeur ou d'un espace de vapeur (18, 18.1) avec au moins un espace de liquide ou un canal de liquide (16) en relation avec le canal de vapeur (18, 18.1) et formé par une structure poreuse ou capillaire, **caractérisé en ce que** la structure poreuse ou capillaire est formée de particules céramiques, du moins en partie.

2. Dissipateur thermique selon la revendication 1, **caractérisé en ce que** la structure capillaire ou poreuse se compose de particules (8) qui sont liées par bonding ou frittage l'une à l'autre et/ou avec une surface voisine (10) de telle sorte qu'il en résulte des voies de circulation capillaires entre les particules (8).

3. Dissipateur thermique selon l'une des revendications 1 ou 2, **caractérisé par** plusieurs montants (6) en traversant l'espace interne, séparés spatialement l'un de l'autre et s'étendant entre deux parois ou segments de parois délimitant l'espace interne et se faisant face, les montants (6) ainsi que les segments de paroi (3, 4) se faisant face se composant respectivement d'un matériau de conductibilité thermique élevée, par exemple d'un métal, par exemple de cuivre et chaque montant (6) étant relié directement à ses deux extrémités avec l'un des segments de paroi (3, 4) se faisant face.

4. Dissipateur thermique selon l'une des revendications précédentes, **caractérisé en ce que** les particules sont composées de métal et/ou de céramique et/ou que les particules (8) sont reliées entre elles par l'intermédiaire de ponts métalliques, par exemple de ponts de cuivre (9), par exemple par l'intermédiaire de ponts de cuivre établis par des bonds DCB.

5. Dissipateur thermique selon l'une des revendications précédentes **caractérisé en ce que** la structure capillaire ou poreuse est formée, du moins dans une zone partielle, d'un déversement en vrac de particules (8) dans un espace (32) qui est séparé par une cloison intermédiaire (31) de l'espace de liquide, la cloison intermédiaire (31) présentant par exemple une multitude d'ouvertures.

6. Dissipateur thermique selon l'une des revendications précédentes, **caractérisé en ce que** la structure capillaire est formée d'au moins une couche ou strate (7) qui est appliquée au moins sur une partie de la surface interne (10) des segments de parois délimitant au moins un espace interne (2) et ce de manière à renfermer les montants (6) sur leurs zones de liaison respectives avec ces segments de paroi (3, 4)
et/ou
que la couche formant la structure capillaire est appliquée du moins sur une zone partielle de la surface des montants (6)
et/ou
que les montants (6) présentent une section qui est essentiellement inférieure, dans chaque direction de section, à la dimension de l'espace interne dans cette direction de section.

7. Dissipateur thermique selon l'une des revendications précédentes, **caractérisé en ce qu'**il est prévu au moins une cloison interne (17, 17.1, 29) entre l'espace de vapeur (18, 18.1) et la structure capillaire formant au moins un canal de liquide,
la cloison intermédiaire au moins (17, 17. 1, 29) étant par exemple dotée d'une multitude d'ouvertures et/ou se composant d'un matériau perforé et/ou se trouvant parallèlement aux premiers segments de paroi (3, 4) et/ou étant formé par une section tubulaire (29), de préférence par une section tubulaire déformée en une section ovale ou pressée à plat.

8. Dissipateur thermique selon l'une des revendications précédentes, **caractérisé en ce qu'**au moins deux structures capillaires et/ou au moins de canaux de vapeur (18, 18.1) formant respectivement un canal de liquide (16) sont respectivement prévus.

9. Dissipateur thermique selon l'une des revendications 3 à 8 précédentes, **caractérisé en ce que** les premier et deuxième segments de paroi sont respectivement formés de cloisons (3, 4) en forme de plaques qui délimitent avec une paroi périphérique (5) l'espace interne du dissipateur thermique et/ou que les premiers segments de paroi sont formés de zones d'un segment tubulaire délimitant l'espace interne du dissipateur thermique, de préférence pressé à plat.

10. Dissipateur thermique selon la revendication 3, **caractérisé en ce qu'**il se compose de plusieurs plaques (3, 4, 19) reliées l'une à l'autre à plat et disposées l'une au-dessus de l'autre en pile, dont les plaques disposées à l'intérieur dans la pile sont dotées d'ouvertures (20), qu'une structure de canal formant l'espace interne du dissipateur thermique est obtenue au travers de ces ouvertures et que les plaques structurées (19) se complètent par des zones situées à l'extérieur des ouvertures (20) vers les montants (6) traversants et qu'un matériau formant la structure capillaire est introduit dans au moins une zone (21) de la structure de canal.

11. Dissipateur thermique selon la revendication 10, **caractérisé en ce que** l'espace interne (26, 28) est formé par au moins un creux ou évidement (25) dans une plaque (23, 24) formant le dissipateur thermique.

12. Dissipateur thermique selon l'une des revendications précédentes, **caractérisé en ce que** les particules (8) formant la couche ou structure (7) capillaire sont prévues en une seule couche sur la surface correspondante (10) de la cloison délimitant l'espace intérieur, les particules (8) étant par exemple liées directement avec la surface respective (10), par exemple par des bonds DCB.

13. Dissipateur thermique selon l'une des revendications précédentes, **caractérisé en ce que** le corps du dissipateur thermique est formé par une pièce tubulaire (29) fermée aux deux extrémités.

14. Procédé de fabrication d'un dissipateur thermique selon la revendication 1, conçu comme un heat-pipe, avec au moins un canal de vapeur conçu dans un espace interne fermé et avec au moins un canal de liquide doté d'une structure poreuse ou capillaire, **caractérisé en ce**
**que** la structure poreuse ou capillaire est produite par introduction d'un déversement en vrac de particules céramiques (8) dans le canal de liquide ainsi que par bonding DCB consécutif en cas de chauffage à une température de bonding de l'ordre de 1065 à 1085°C.

15. Procédé selon la revendication 14, **caractérisé en ce**
**que** la structure capillaire ou poreuse est produite par l'introduction d'un mélange ou d'un déversement en vrac de particules dans le canal de liquide à partir d'un matériau résistant à la chaleur et d'oxyde de cuivre pulvérulent ou de particules de cuivre oxydées ainsi que par bonding DCB consécutif.

16. Procédé selon l'une de revendications 14 ou 15, **caractérisé par** l'utilisation d'un déversement en vrac ou d'un mélange qui contient par ailleurs des particules de cuivre.

17. Procédé selon l'une des revendications 14 à 16 précédentes, **caractérisé en ce que** la proportion excédentaire et non liée du déversement en vrac ou du mélange est éliminée après le refroidissement et le bonding.

18. Procédé selon l'une des revendications 14 à 17 précédentes, caractérisant ce que la structure capillaire ou poreuse ou la couche est produite avant la fermeture de l'espace interne du dissipateur thermique.

19. Procédé selon l'une de revendications 14 à 18 précédentes, **caractérisé en ce que** le déversement en vrac ou le mélange formant la structure capillaire est introduit par au moins une ouverture dans l'espace interne et y est réparti avant le bonding, par exemple par agitation, vibration et/ou retournement.

20. Procédé selon l'une des revendications 14 à 19 précédentes, **caractérisé en ce que**, pour la confection de la structure poreuse ou capillaire, au moins une partie de l'espace interne du dissipateur thermique formant un espace de vapeur est remplie par un milieu de support (30, 31) ou dégagée avant le bonding des particules formant la structure poreuse ou capillaire, le milieu de support (30), par exemple, étant éliminé ou restant dans le dissipateur thermique après le bonding ou après la confection de la structure poreuse ou capillaire.

21. Procédé selon la revendication 10 **caractérisé en ce que** le milieu de support (30) est un milieu sous forme de particules, par exemple de particules d'un matériau résistant à la chaleur sans le matériau de bonding.

22. Procédé selon l'une de revendications 20 et 21 précédentes, **caractérisé en ce que** le milieu de support est formé par une paroi (31), par exemple par un segment tubulaire formant cette paroi.
